# EUROPEAN PATENT APPLICATION

(11) **EP 4 376 053 A1**
(43) Date of publication of application: **29.05.2024**
(21) Application number: 22845723.0
(22) Date of filing: 20.06.2022
(51) Int. Cl.: H01L 21/02, H01L 21/20

(54) **BONDED WAFER AND METHOD FOR MANUFACTURING BONDED WAFER**

(30) Priority: 19.07.2021 JP 2021119077
(71) Applicant: Shin-Etsu Handotai Co., Ltd., Tokyo 100-0004 (JP)
(72) Inventor: ISHIZAKI Junya, Annaka-shi, Gunma 379-0196 (JP); AKIYAMA Tomohiro, Annaka-shi, Gunma 379-0196 (JP); FURUYA Shogo, Annaka-shi, Gunma 379-0196 (JP)
(74) Representative: Mooser, Sebastian Thomas
(86) International application number: PCT/JP2022/024450
(87) International publication number: WO 2023/002787

(57) **Abstract**

The present invention is a bonded wafer, wherein an epitaxial wafer having a heterojunction structure, in which a material with a different thermal expansion coefficient is epitaxially laminated on a growth substrate, and a support substrate are bonded via a bonding material, wherein the bonding material has an average thickness of 0.01 um or more and 0.6 um or less. As a result, provided is a bonded wafer and a method for producing the same that improves the film thickness distribution of the bonding material caused by the warpage of the semiconductor epitaxial substrate and the warpage that changes with thermal changes when the warped semiconductor epitaxial substrate and the support substrate are bonded together using the bonding material

## Description

### TECHNICAL FIELD

The present invention relates to a bonded wafer in which a support substrate is bonded to an epitaxial wafer in which a compound semiconductor functional layer is epitaxially grown on a growth substrate (starting substrate).

### BACKGROUND ART

A technique of separating only an epitaxial functional layer from a starting substrate and transferring it to another substrate is an important technique for alleviating restrictions caused by physical properties of the starting substrate and increasing degree of freedom in device system design.
In order to realize the transfer, a technique for removing the starting substrate after bonding the epitaxial functional layer to the support substrate and realizing the transfer is required.

Patent Document 1 discloses a technique of thermocompression bonding a semiconductor epitaxial substrate and a temporary support substrate via a dielectric layer, and a technique of separating the temporary support substrate and the epitaxial functional layer by wet etching. If the semiconductor epitaxial substrate has a large degree of warpage, there is a problem in that the bonding quality after bonding deteriorates. In particular, the problem does not appear immediately after bonding, but after the removal of the starting substrate, there is a problem that unevenness occurs on the substrate-removed surface and a difference in height (concave or convex) occurs in the surface.

In Patent Document 2, a technique in which a transparent conductive layer is inserted between an adhesive layer and a functional layer as one embodiment of bonding is disclosed, although it is not directly related to improving bondability.

When an optically functional layer such as a light-receiving or light-emitting element is bonded through a bonding material that is transparent to incident light or emitted light, there are limits to the film thickness that can be optically selected. In order to suppress multiple reflections within the transparent bonding layer, it is advantageous to increase the thickness of the transparent bonding layer.

In addition, since an increased thickness of the bonding layer enhances the mechanical strength, even if stress due to design exist in the semiconductor epitaxial substrate, the strength of the bonding layer is not compromised, and the epitaxial layer after removal of the starting substrate is maintained. This has the effect of preventing the remaining epitaxial layer from peeling off from the substrate to be bonded when the starting substrate is removed. Therefore, an increased thickness of the bonding layer is advantageous in terms of optical design and mechanical aspects.

However, when the bonding layer has an increased thickness, the thickness of the bonding layer tends to have a distribution at the time of bonding. The bonding material has a thermosetting property, in other words, it is necessary to raise the temperature above room temperature in order to cure it. A semiconductor epitaxial substrate is a laminate of materials different from the starting substrate, and the thermal expansion coefficient differs for each material. Therefore, raising the temperature is essentially synonymous with changing the warpage of the semiconductor epitaxial substrate.

The bonding material is in a soft state before it is thermally cured, and a film thickness distribution occurs due to warpage of the semiconductor epitaxial substrate. The film thickness distribution of the bonding material immediately after coating is ±5% or less, but if the semiconductor epitaxial substrate has a convex warpage, the bonding material at the center of the wafer becomes thin, and if it has a concave shape, it becomes thick. Furthermore, this warpage also changes due to temperature changes.

Applying pressure to the substrate is effective in correcting the warpage of the semiconductor epitaxial substrate, but a film thickness distribution of the bonding material occurs along the warped shape before compression bonding. Once a film thickness distribution occurs, even a subsequent softening treatment cannot achieve significant improvement thereof.

As a result, when a warped semiconductor epitaxial substrate and a support substrate are bonded using a thermosetting type bonding material, there is a problem that there is a large distribution in the film thickness of the bonding material.

### CITATION LIST

### PATENT LITERATURE

Patent Document 1: JP 2021-27301 A
Patent Document 2: JP 4159421 B

### SUMMARY OF INVENTION

### TECHNICAL PROBLEM

The present invention has been made to solve the above problems, and an object of the present invention is to provide a bonded wafer and a method for producing the same that improves the film thickness distribution of the bonding material caused by the warpage of the semiconductor epitaxial substrate and the warpage that changes with thermal changes when the warped semiconductor epitaxial substrate and the support substrate are bonded together using the bonding material.

### SOLUTION TO PROBLEM

In order to solve the above problems, the present invention provides:
a bonded wafer, wherein an epitaxial wafer having a heterojunction structure, in which a material with a different thermal expansion coefficient is epitaxially laminated on a growth substrate, and a support substrate are bonded via a bonding material,
wherein the bonding material has an average thickness of 0.01 um or more and 0.6 um or less.

In this way, by setting the thickness of the bonding material to 0.01 um or more and 0.6 um or less, even when a warped wafer such as an epitaxial wafer with a heterojunction structure is bonded to a support substrate, the bonding material has a ratio of twice or less between the maximum film thickness and the minimum film thickness.

Further, it is preferable that the bonding material is of a thermosetting type and has a thermal softening point lower than a thermosetting temperature.

Further, the bonding material preferably comprises one or more of epoxy resin, benzocyclobutene (BCB), SOG (spin-on-glass), PI (polyimide), and fluororesin.

In the present invention, such a bonding material can be suitably used.

Also, the bonding material may be in a softened state.

If the bonding material is in a softened state, the support substrate can be easily separated when peeling is required.

Moreover, the present invention provides:
a method for producing a bonded wafer comprising:
   (1) a step of producing an epitaxial wafer having a heterojunction structure by laminating a material with a different thermal expansion coefficient on a growth substrate by epitaxial growth,
   (2) a step of preparing a support substrate, and
   (3) a step of bonding an epitaxial growth layer of the epitaxial wafer and the support substrate via a bonding material,
wherein the bonding material has an average thickness of 0.01 um or more and 0.6 um or less.

By setting the thickness of the bonding material to 0.01 um or more and 0.6 um or less in this way, even when a warped wafer such as an epitaxial wafer having a heterojunction structure is bonded to a support substrate, it is possible to relatively easily produce a bonded wafer in which the bonding material has a ratio of twice or less between the maximum film thickness and the minimum film thickness.

Moreover, it is preferable that the bonding material is of a thermosetting type and has a thermal softening point lower than a thermosetting temperature.

Further, it is preferable that the bonding material comprises one or more of epoxy resin, benzocyclobutene (BCB), SOG (spin-on-glass), PI (Polyimide), and fluororesin.

In the present invention, such a bonding material can be suitably used.

Moreover, the present invention provides:
a method for producing a bonded wafer comprising:
   (1) a step of producing an epitaxial wafer having a heterojunction structure by laminating a material with a different thermal expansion coefficient on a growth substrate by epitaxial growth,
   (2) a step of preparing a support substrate, and
   (3) a step of bonding an epitaxial growth layer of the epitaxial wafer and the support substrate via a bonding material,
wherein a thermosetting material is applied and cured on the epitaxial growth layer, and the support substrate is further bonded thereon via the bonding material having an average thickness of 0.01 um or more and 0.6 um or less.

With such a producing method, even if the bonding material is required to have a certain thickness to some extent, the film thickness distribution of the bonding material can be improved.

### ADVANTAGEOUS EFFECTS OF INVENTION

As described above, according to the present invention, it is possible to provide a bonded wafer and a method for producing the same that improves the film thickness distribution of the bonding material caused by the warpage of the semiconductor epitaxial substrate and the warpage that changes with thermal changes when the warped semiconductor epitaxial substrate and the support substrate are bonded together using the bonding material.

### BRIEF DESCRIPTION OF DRAWINGS

FIG. 1 is a graph showing a relationship between the designed film thickness of a bonding material and the in-plane thickness distribution (maximum film thickness and minimum film thickness), which was discovered in the present invention;
FIG. 2 is a graph showing a relationship between the diameter of an epitaxial wafer and the in-plane thickness distribution (maximum film thickness and minimum film thickness) of a bonding material when the wafer and a support substrate are bonded via the bonding material;
FIG. 3 is a schematic view when an epitaxial wafer is produced by growing an epitaxial growth layer on a growth substrate in the first embodiment of the method for producing a bonded wafer of the present invention;
FIG. 4 is a schematic view when a bonded wafer is produced by bonding a support substrate (silicon wafer) to an epitaxial growth layer via a bonding material (BCB) in the first embodiment of the method for producing a bonded wafer of the present invention;
FIG. 5 is a schematic view when the growth substrate is removed from the bonded wafer in the first embodiment of the method for producing a bonded wafer of the present invention;
FIG. 6 is a graph showing a relationship between the total film thickness (design thickness) of the lower cured layer and the bonding material layer and the in-plane thickness distribution (maximum film thickness and minimum film thickness) in the second embodiment of the method for producing a bonded wafer of the present invention;
FIG. 7 is a schematic view when an epitaxial wafer is produced by growing an epitaxial growth layer on a growth substrate in the second embodiment of the method for producing a bonded wafer of the present invention;
FIG. 8 is a schematic view when a thermosetting material (BCB) is applied and cured on the epitaxial growth layer in the second embodiment of the method for producing a bonded wafer of the present invention;
FIG. 9 is a schematic view when a bonding material (BCB) is applied on the cured thermosetting material (BCB) in the second embodiment of the method for producing a bonded wafer of the present invention;
FIG. 10 is a schematic view when a bonded wafer is produced by bonding a support substrate (silicon wafer) via a bonding material (BCB) in the second embodiment of the method for producing a bonded wafer of the present invention; and
FIG. 11 is a schematic view when the growth substrate is removed from the bonded wafer in the second embodiment of the method for producing a bonded wafer of the present invention.

### DESCRIPTION OF EMBODIMENTS

As described above, there is a need for a bonded wafer and a method for producing the same that improves the film thickness distribution of the bonding material caused by the warpage of the semiconductor epitaxial substrate and the warpage that changes with thermal changes when the warped semiconductor epitaxial substrate and the support substrate are bonded together using the thermosetting type bonding material.

The inventors of the present invention have conducted extensive studies and have found that by setting the design (average) thickness of the bonding material to 0.01 um or more and 0.6 um or less, the bonding material layer has an in-plane thickness distribution in which the maximum film thickness is twice or less the minimum film thickness, and have completed the present invention.

That is, the present invention is a bonded wafer, wherein an epitaxial wafer having a heterojunction structure, in which a material with a different thermal expansion coefficient is epitaxially laminated on a growth substrate, and a support substrate are bonded via a bonding material, wherein the bonding material has an average thickness of 0.01 um or more and 0.6 um or less.

Hereinafter, the present invention will be described in detail, but the present invention is not limited thereto.

### [Bonded wafer]

The bonded wafer of the present invention is a bonded wafer in which an epitaxial wafer having a heterojunction structure and a support substrate are bonded via a bonding material, and the average thickness of the bonding material is set to 0.01 um or more and 0.6 um or less. By setting the average thickness of the bonding material to 0.6 um or less, it is possible to reduce the thickness distribution of the bonding material caused by warpage of the wafer and warpage due to thermal changes.

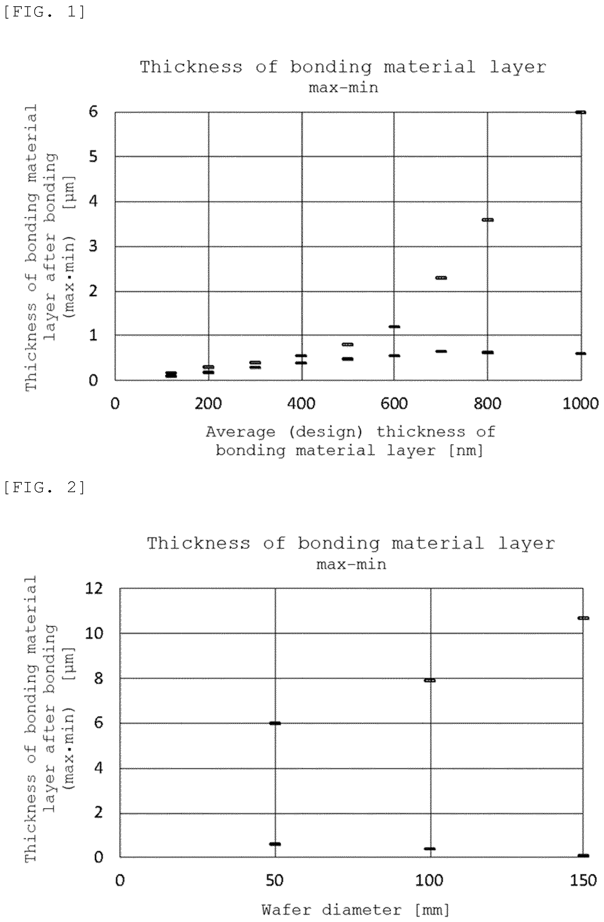

The inventors of the present invention investigated the thickness distribution of the bonding material layer when bonding a warped wafer and a support substrate by providing a thermosetting type bonding material layer. Conventionally, a bonding material layer has had a thickness distribution caused by the influence of warpage. FIG. 2 shows the relationship of the in-plane thickness variations (maximum and minimum values) of the bonding material for each wafer diameter when an epitaxial wafer having a concave warp in the epitaxial growth direction and a support substrate is bonded via a bonding material. The thickness of the bonding material layer in FIG. 2 is a value when the design thickness is constant at 1 um, and the curing conditions for the bonding material are unified at 250°C for 1 hour.

Relatively large warpage remained in the epitaxial wafers: BOW ≒ 100 um for diameter 2"Φ (50 mm), BOW ≒ 400 um for diameter 4"Φ (100 mm), and BOW ≒ 1400 to 1600 um for diameter 6"Φ (150 mm).

A thermosetting bonding material is cured by being held at a constant temperature at a curing treatment temperature, but always passes through the softening point once before reaching the curing point. While the temperature is rising, pressing pressure is applied from above and below to suppress thermal deformation (warpage deformation) of the wafer, but since the bonding material layer corresponding to a pedestal is softened, the effect of suppressing wafer deformation is lost, and the thickness of the bonding material layer changes along the deformation of the wafer. If the wafer has a concave warp, the thickness of the bonding material layer in the outer peripheral portion of the wafer becomes thin, and the thickness of the bonding material layer in the central portion of the wafer becomes thick.

Once deformed, the bonding material layer cannot be corrected by vertical pressing pressure and reaches the curing temperature as it is, so the thickness distribution of the bonding material layer is preserved, and as a result, it is cured while the thickness distribution of the bonding material layer remains unchanged.

Although not shown, this tendency worsens as the thickness of the bonding material layer increases. In the case of a light-emitting element, a change in the height of the element causes a change in optical characteristics (especially light distribution characteristics). This causes variations in characteristics, which is a problem.

On the other hand, as shown in FIG. 1, the in-plane thickness distribution of the bonding material layer tends to be minimized by gradually decreasing the design thickness (average thickness) of the bonding material layer from 1 um. Particularly in the thickness region of 0.6 um or less, the maximum film thickness can be kept to twice or less of the minimum film thickness, and can also be kept to twice or less of the design thickness. In order to maintain uniformity in light distribution characteristics, it is necessary to maintain a height variation of ±1 um or less, but in Fig. 1, in the region where the design thickness (spin coating thickness) of the bonding material layer is 0.6 µm or less, this height distribution can be maintained, and variations in device characteristics can be kept within an allowable range.

In addition, a bonding material such as BCB, which will be described later, is a material transparent to the emission wavelength, and a technology is disclosed in which sapphire or quartz, which is transparent to the emission wavelength, is used as a support substrate and light is extracted from the support substrate. In this case, since the refractive index of the bonding material is different from that of the transparent support substrate, an excessively thin bonding material layer may cause multiple reflections within the bonding material layer to reduce the light extraction efficiency. In order to avoid this, it is possible to reduce the influence of multiple reflections by increasing the design film thickness of the bonding material layer.

In the bonded wafer of the present invention, the average thickness of the bonding material is 0.01 um or more. If the thickness is less than 0.01 um, problems such as a decrease in light extraction efficiency due to multiple reflections and a decrease in area yield after bonding may occur.

Moreover, it is preferable that the bonding material is of a thermosetting type and has a thermal softening point lower than the thermosetting temperature. Furthermore, the bonding material preferably comprises one or more of epoxy resin, benzocyclobutene (BCB), SOG (spin-on-glass), PI (polyimide), and fluororesin.

Furthermore, although the bonding material may be cured, it may also be in a softened state. If the bonding material is in a softened state, the support substrate can be easily separated when peeling is required.

In the bonded wafer of the present invention, there are no particular limitations on the growth substrate, the material for epitaxial growth, and the support substrate.

### [Method for producing bonded wafer]

The present invention also provides a method for producing a bonded wafer. The method for producing a bonded wafer according to the present invention will be described in more detail below with reference to the drawings, but the present invention is not limited thereto.

### (First embodiment)

The first embodiment of the method for producing a bonded wafer of the present invention is:
a method for producing a bonded wafer comprising:
   (1) a step of producing an epitaxial wafer having a heterojunction structure by laminating a material with a different thermal expansion coefficient on a growth substrate by epitaxial growth,
   (2) a step of preparing a support substrate, and
   (3) a step of bonding an epitaxial growth layer of the epitaxial wafer and the support substrate via a bonding material,
wherein the bonding material has an average thickness of 0.01 um or more and 0.6 um or less.

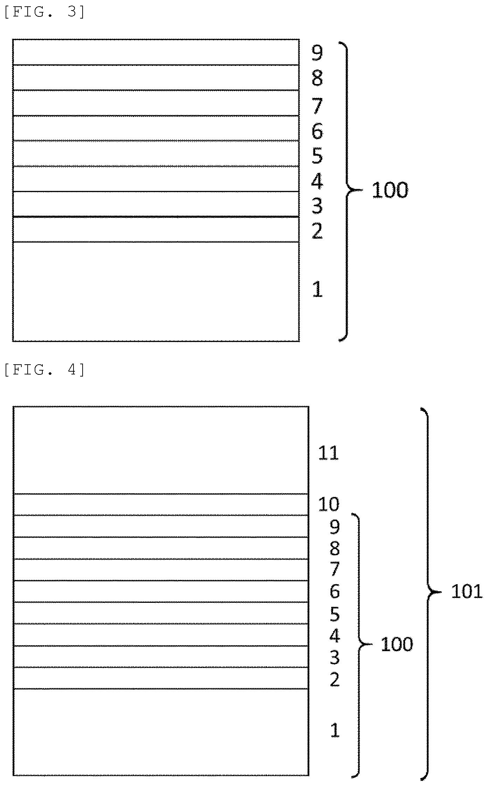

The first embodiment of the method for producing a bonded wafer will be described with reference to FIGS. 3 to 5.

First, as shown in FIG. 3, a semiconductor epitaxial wafer 100 having a light emitting element structure as an epitaxial growth layer (functional layer) is prepared by laminating a first conductivity type GaAs buffer layer 2 on a first conductivity type GaAs growth substrate 1, and then sequentially growing a first conductivity type GaInP first etch stop layer 3: for example 0.3 um, a first conductivity type GaAs second etch stop layer 4: for example 0.3 um, a first conductivity type AlGaInP first cladding layer 5: for example 1.0 um, a non-doped AlGaInP active layer 6, a second conductivity type AlGaInP second cladding layer 7: for example 1.0 um, a second conductivity type GaInP intermediate layer 8: for example 0.1 um, and a second conductivity type GaP window layer 9: for example 4 um. Here, from the AlGaInP first cladding layer 5 to the AlGaInP second cladding layer 7 are referred to as a double hetero structure portion.

Next, as shown in FIG. 4, benzocyclobutene (BCB), for example, is spin-coated as a thermosetting type bonding material 10 on the epitaxial growth layer of the epitaxial wafer 100, and a silicon wafer 11 as a support substrate is faced, superimposed, and thermocompression bonded thereto. Thus a bonded wafer 101 is produced in which the epitaxial wafer 100 and the silicon wafer 11 are bonded via the bonding material 10. When BCB is applied by spin coating, the design film thickness is 0.01 um or more and 0.6 um or less.

The support substrate is not limited to a silicon wafer, and any material can be selected as long as flatness is ensured. Although it is possible to select a compound semiconductor wafer such as GaAs or InP, from a cost standpoint, it is preferable to select sapphire, quartz, or Ge in addition to silicon.

Further, the thermosetting type bonding material 10 is not limited to BCB, and any material can be selected as long as it has thermosetting properties. In addition to BCB, epoxy resin, SOG (spin-on-glass), PI (polyimide), fluororesin, etc. may be used.

In this embodiment, illustrated is a case where thermocompression bonding is performed and the thermosetting type bonding material 10 is thermally cured. The bonding is not limited to a state that the bonding material 10 is thermally cured, since a bond is only necessarily achieved. In the case of the exemplified BCB, a bond is achieved even when the temperature reaches the softening point 150°C, and then is lowered to room temperature.

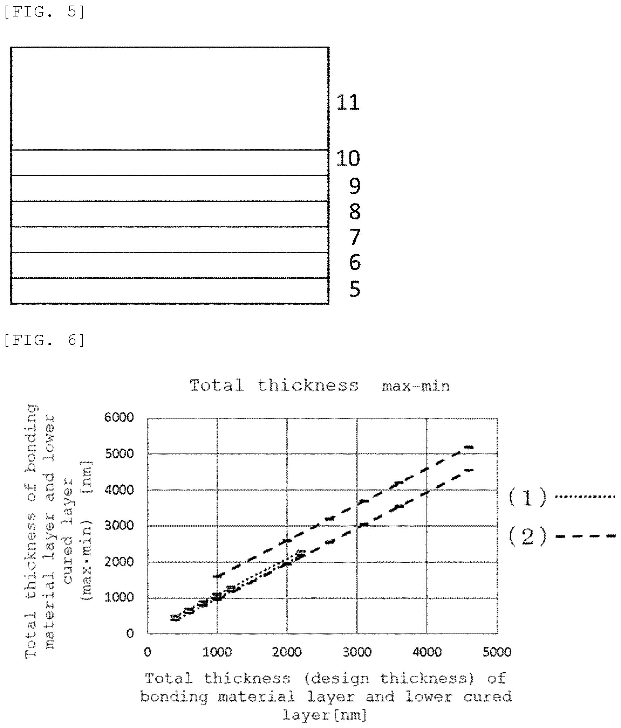

Next, as shown in FIG. 5, the GaAs growth substrate 1 is removed by wet etching treatment using a selective etching solution such as ammonia hydrogen peroxide, and the GaInP first etch stop layer 3 is exposed. The GaInP first etch stop layer 3 is selectively removed by switching the etchant to a hydrochloric acid base etchant, and the GaAs second etch stop layer 4 is exposed. The GaAs second etch stop layer 4 is selectively removed by switching the etchant to a sulfuric acid hydrogen peroxide base etchant, and the first cladding layer 5 is exposed. By performing the above treatment, a bonded wafer holding only the double hetero layer and the window layer is produced.

Here, the design thickness of the bonding material such as BCB is 0.01 um or more and 0.6 um or less, but since the bonding material is formed by spin coating, if it is too thin, the area yield after bonding tends to decrease. In order to maintain an area yield of 90% or more after bonding, it is preferable to design the bonding material layer thickness to be 0.05 um or more. Furthermore, if it is sufficient to maintain a bonding area yield of 70% or more, this can be achieved by designing the bonding material layer thickness to be 0.01 um or more.

### (Second embodiment)

The second embodiment of the method for producing a bonded wafer of the present invention is:
a method for producing a bonded wafer comprising:
   (1) a step of producing an epitaxial wafer having a heterojunction structure by laminating a material with a different thermal expansion coefficient on a growth substrate by epitaxial growth,
   (2) a step of preparing a support substrate, and
   (3) a step of bonding an epitaxial growth layer of the epitaxial wafer and the support substrate via a bonding material,
wherein a thermosetting material is applied and cured on the epitaxial growth layer, and the support substrate is further bonded thereon via the bonding material having an average thickness of 0.01 um or more and 0.6 um or less.

There is a trade-off between improving the film thickness distribution of the bonding material layer after bonding by making the bonding material layer thinner and improving light extraction efficiency (external quantum efficiency) by making the bonding material layer thicker, but the above-mentioned trade-off conditions can be avoided by providing a lower cured layer formed by curing a thermosetting material, and then forming a bonding material layer thereon and bonding.

FIG. 6 shows the relationship between the total film thickness (design film thickness) of the lower cured layer and the bonding material layer and the in-plane thickness distribution (maximum value-minimum value) in the case of bonding 2"Φ wafers. (1) of FIG. 6 shows data of distribution of the total thickness of the bonding material layer and the lower cured layer after bonding when the design thickness of the bonding material layer is set to 0.2 um and the design thickness of the lower cured layer is changed from 0.4 to 2.2 um. The design thickness becomes from 0.6 to 2.4 um. In the case of conventional technology, the film thickness distribution is from 0.6 to 6 um for the design thickness of 1 um. Therefore, the film thickness distribution can be significantly improved. Also, the deviation from the design thickness is relatively small.

(2) of FIG. 6 shows data of distribution of the total thickness of the bonding material layer and lower cured layer after bonding when the design thickness of the bonding material layer is set to 0.6 um and the thickness of the lower cured layer is changed from 0.0 to 4.0 um in the case of bonding 2"Φ wafers. Although the deviation is larger than in the case of (1) in FIG. 6, the deviation do not exceed the film thickness that is twice the design film thickness. That is, by using the method of the present invention, warped epi-wafers can be bonded via a thick bonding material layer without increasing the thickness distribution of the bonding material layer.

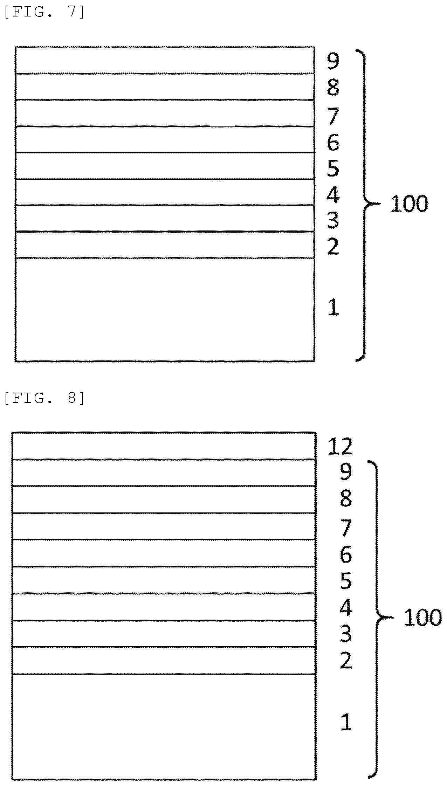

The second embodiment of the method for producing a bonded wafer will be described using FIGS. 7 to 11.

First, as shown in FIG. 7, a semiconductor epitaxial wafer 100 having a light emitting device structure as an epitaxial growth layer (functional layer) is prepared by laminating a first conductivity type GaAs buffer layer 2 on a first conductivity type GaAs growth substrate 1, and then sequentially growing a first conductivity type GaInP first etch stop layer 3: for example 0.3 um, a first conductivity type GaAs second etch stop layer 4: for example 0.3 um, a first conductivity type AlGaInP first cladding layer 5: for example 1.0 um, a non-doped AlGaInP active layer 6, a second conductivity type AlGaInP second cladding layer 7: for example 1.0 um, a second conductivity type GaInP intermediate layer 8: for example 0.1 um, and a second conductivity type GaP window layer 9: for example 4.0 um. Here, the AlGaInP first cladding layer 5 to the AlGaInP second cladding layer 7 are referred to as a double hetero structure portion.

Next, as shown in FIG. 8, benzocyclobutene (BCB) is spin-coated as a thermosetting material 12 onto the epitaxial growth layer of the epitaxial wafer 100. The design film thickness at that time can be, for example, 0.5 um. After the spin coating, the wafer is held on a hot plate heated to 250°C for 1 hour to form a lower cured layer of cured BCB.

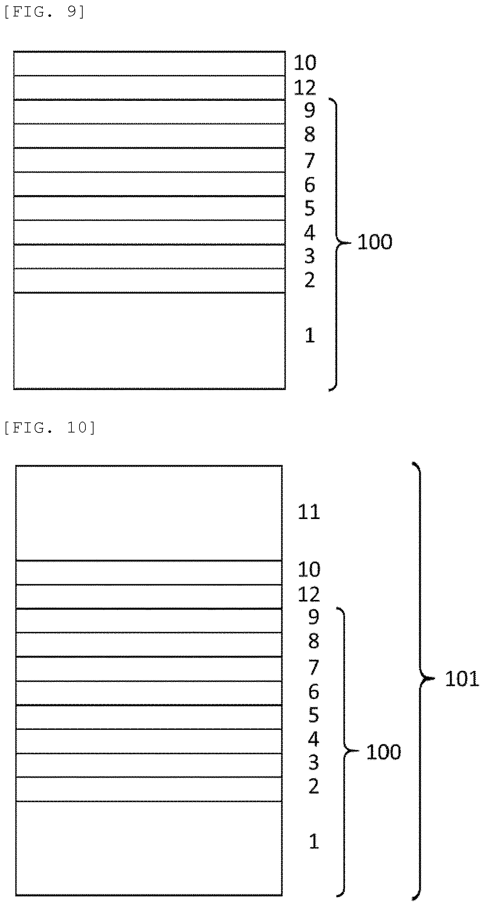

Next, as shown in FIG. 9, after forming a lower cured layer, benzocyclobutene (BCB) as a bonding material 10 is spin-coated to form a bonding material layer. At that time, the design film thickness of the bonding material layer is set to 0.01 um or more and 0.6 um or less.

Next, as shown in FIG. 10, after forming a bonding material layer, the bonding material 10 and the silicon wafer 11, which is a support substrate, are faced, superimposed, and thermocompression bonded to each other, thereby producing a bonded wafer 101 in which the epitaxial wafer 100 and the silicon wafer 11 are bonded with each other via the bonding material 10 and the thermosetting material 12.

The support substrate is not limited to a silicon wafer, and any material can be selected as long as flatness is ensured. Although it is possible to select a compound semiconductor wafer such as GaAs or InP, from a cost standpoint, it is preferable to select sapphire, quartz, or Ge in addition to silicon.

Furthermore, the thermosetting type bonding material 10 and the thermosetting material 12 for forming the lower cured layer are not limited to BCB. It is possible to select any material as long as it has thermosetting properties. In addition to BCB, epoxy resin, SOG (spin-on-glass), PI (polyimide), fluororesin, etc. may be used. Further, it is preferable that the bonding material 10 and the thermosetting material 12 are the same material.

In this embodiment, illustrated is a case where thermocompression bonding is performed and the thermosetting type bonding material 10 is thermally cured. The bonding is not limited to a state that the bonding material 10 is thermally cured, since a bond is only necessarily achieved. In the case of the exemplified BCB, a bond is achieved even when the temperature reaches the softening point 150°C, and then is lowered to room temperature.

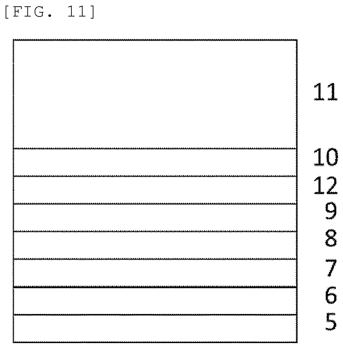

Next, as shown in FIG. 11, the GaAs growth substrate 1 is removed by wet etching treatment using a selective etching solution such as ammonia hydrogen peroxide, and the GaInP first etch stop layer 3 is exposed. The GaInP first etch stop layer 3 is selectively removed by switching the etchant to a hydrochloric acid base etchant, and the GaAs second etch stop layer 4 is exposed. The GaAs second etch stop layer 4 is selectively removed by switching the etchant to a sulfuric acid hydrogen peroxide base etchant, and the first cladding layer 5 is exposed. By performing the above treatment, a bonded wafer holding only the double hetero layer and the window layer is produced.

In addition, in the present embodiment, illustrated is a case where the lower cured layer made of a cured thermosetting material provided under the bonding material layer has a film thickness of 0.5 um, but the thickness is not limited to this thickness, for example, it can be set to 0.01 um to 5.0 um. The thickness of the lower cured layer can be freely selected. As the thickness of the lower cured layer increases, the mechanical strength of the epitaxial layer remaining after removal of the growth substrate increases, and the effect of suppressing peeling increases.

Here, since the bonding material is formed by spin coating, if the thickness of the bonding material is too thin, the area yield after bonding tends to decrease. In order to maintain an area yield of 90% or more after bonding, it is preferable to design the bonding material layer thickness to be 0.05 um or more. Furthermore, if it is sufficient to maintain a bonding area yield of 70% or more, this can be achieved by designing the bonding material layer thickness of 0.01 um or more.

### EXAMPLE

The present invention will be specifically described below using Examples and a Comparative Example, but the present invention is not limited to these.

### (Example 1)

A semiconductor epitaxial wafer having a light emitting device structure as an epitaxial growth layer was prepared by laminating a first conductivity type GaAs buffer layer on a first conductivity type GaAs growth substrate, and then sequentially growing a first conductivity type GaₓIn₁₋ₓP (0.4≦x≦0.6) first etch stop layer: 0.3 um, a first conductivity type GaAs second etch stop layer: 0.3 um, a first conductivity type (Al_{y}Ga_{1-y})ₓIn₁₋ₓP (0.4≦x≦0.6, 0<y≦1) first cladding layer: 1.0 um, a non-doped (Al_{y}Ga_{1-y})ₓIn₁₋ₓP (0.4≦x≦0.6, 0≦y≦0.6) active layer, a second conductivity type (Al_{y}Ga_{1-y})ₓIn₁₋ₓP (0.4≦x≦0.6, 0<y≦1) second cladding layer: 1.0 um, a second conductivity type GaInP intermediate layer: 0.1 um, and a second conductivity type GaP window layer: 4 um.

Benzocyclobutene (BCB) as a thermosetting type bonding material was spin-coated on the semiconductor epitaxial wafer to form a bonding material layer, and a silicon wafer as a support substrate is faced, superimposed, and thermocompression bonded thereto, and thereby a first bonded wafer was produced in which the semiconductor epitaxial wafer and the silicon wafer are bonded via BCB. When BCB was applied by spin coating, the design film thickness was set to 0.6 um.

The GaAs growth substrate is removed by wet etching treatment with ammonia hydrogen peroxide to expose the GaInP first etch stop layer. The GaInP first etch stop layer is selectively removed by switching the etchant to a hydrochloric acid base etchant, and the GaAs second etch stop layer is exposed. The GaAs second etch stop layer is selectively removed by switching the etchant to a sulfuric acid hydrogen peroxide base etchant, and the first cladding layer is exposed. By performing the above treatment, a second bonded wafer holding only the double hetero layer and the window layer was produced.

When the thickness distribution of the bonding portion of this bonded wafer was investigated, the ratio of the maximum film thickness to the minimum film thickness was 1.9 times. It was found that the thickness distribution was significantly improved compared to the comparative example described below.

### (Example 2)

A semiconductor epitaxial wafer having a light emitting device structure as an epitaxial growth layer was prepared by laminating a first conductivity type GaAs buffer layer on a first conductivity type GaAs growth substrate, and then sequentially growing a first conductivity type GaₓIn₁₋ₓP (0.4≦x≦0.6) first etch stop layer: 0.3 um, a first conductivity type GaAs second etch stop layer: 0.3 um, a first conductivity type (Al_{y}Ga_{1-y})ₓIn₁₋ₓP (0.4≦x≦0.6, 0<y≦1) first cladding layer: 1.0 um, a non-doped (Al_{y}Ga_{1-y})ₓIn₁₋ₓP (0.4≦x≦0.6, 0≦y≦0.6) active layer, a second conductivity type (Al_{y}Ga_{1-y})ₓIn₁₋ₓP (0.4≦x≦0.6, 0<y≦1) second cladding layer: 1.0 um, a second conductivity type GaInP intermediate layer: 0.1 um, and a second conductivity type GaP window layer: 4.0 um.

Benzocyclobutene (BCB) is spin-coated as a thermosetting material onto the semiconductor epitaxial wafer. The design film thickness at that time was 0.5 um. After spin coating, the wafer is held on a hot plate heated to 250°C for 1 hour to form a lower cured layer of cured BCB.

After forming the lower cured layer, a bonding material layer is formed by spin-coating benzocyclobutene (BCB) as a bonding material. At that time, the design film thickness of the bonding material layer was set to 0.1 um.

After the bonding material layer was formed, the bonding material layer and a silicon wafer, which is a support substrate, were faced, superimposed, and thermocompression bonded to each other, thereby producing a first bonded wafer in which the semiconductor epitaxial wafer and the silicon wafer were bonded via BCB.

The GaAs growth substrate is removed by wet etching treatment with ammonia hydrogen peroxide to expose the GaInP first etch stop layer. The GaInP first etch stop layer is selectively removed by switching the etchant to a hydrochloric acid base etchant, and the GaAs second etch stop layer is exposed. The GaAs second etch stop layer is selectively removed by switching the etchant to a sulfuric acid hydrogen peroxide base etchant, and the first cladding layer is exposed. By performing the above treatment, a second bonded wafer holding only the DH layer and the window layer was produced.

When the thickness distribution of the bonding portion of this bonded wafer was investigated, the ratio of the maximum film thickness to the minimum film thickness was 1.3 times.

### (Comparative example)

A semiconductor epitaxial wafer having a light emitting device structure as an epitaxial growth layer was prepared by laminating a first conductivity type GaAs buffer layer on a first conductivity type GaAs growth substrate, and then sequentially growing a first conductivity type GaₓIn₁₋ₓP (0.4≦x≦0.6) first etch stop layer: 0.3 um, a first conductivity type GaAs second etch stop layer: 0.3 um, a first conductivity type (Al_{y}Ga_{1-y})ₓIn₁₋ₓP (0.4≦x≦0.6, 0<y≦1) first cladding layer: 1.0 um, a non-doped (Al_{y}Ga_{1-y})ₓIn₁₋ₓP (0.4≦x≦0.6, 0≦y≦0.6) active layer, a second conductivity type (Al_{y}Ga_{1-y})ₓIn₁₋ₓP (0.4≦x≦0.6, 0<y≦1) second cladding layer: 1.0 um, a second conductivity type GaInP intermediate layer: 0.1 um, and a second conductivity type GaP window layer: 4.0 um.

BCB as a bonding material was spin-coated to be 1.0 um on the semiconductor epitaxial wafer, and a sapphire wafer was faced, superimposed, and thermocompression bonded thereto, and thereby a bonded wafer was produced in which the epitaxial wafer and the sapphire wafer were bonded via BCB. At the time of bonding, the temperature of the BCB was set to more than 150°C and 350°C or less. Further, the curing treatment was performed by holding at 250°C for 1 hour.

The GaAs growth substrate is removed by wet etching treatment with ammonia hydrogen peroxide to expose the GaInP first etch stop layer. The GaInP first etch stop layer is selectively removed by switching the etchant to a hydrochloric acid base etchant, and the GaAs second etch stop layer is exposed. The GaAs second etch stop layer is selectively removed by switching the etchant to a sulfuric acid hydrogen peroxide base etchant, and the first cladding layer is exposed. By performing the above treatment, a bonded wafer holding only the double hetero layer and the window layer was produced.

When the thickness distribution of the bonding portion of this bonded wafer was investigated, the ratio of the maximum film thickness to the minimum film thickness was 8.5 times.

As shown in the results of Examples 1 and 2, in the present invention, it can be seen that the thickness distribution of the bonding material caused by warpage can be greatly improved by producing a bonded wafer with the design thickness (average thickness) of the bonding material of 0.6 um or less. On the other hand, as can be seen from the result of Comparative Example 1, when a bonded wafer is produced with the designed thickness of the bonding material thicker than 0.6 um, the thickness distribution of the bonding material becomes large.

Note that the present invention is not limited to the above embodiments. The above-described embodiments are just examples, and any examples that substantially have the same configuration and demonstrate the same functions and effects as those in the technical concept disclosed in the claims of the present invention are included in the technical scope of the present invention.

## Claims

1. A bonded wafer, wherein an epitaxial wafer having a heterojunction structure, in which a material with a different thermal expansion coefficient is epitaxially laminated on a growth substrate, and a support substrate are bonded via a bonding material,
wherein the bonding material has an average thickness of 0.01 um or more and 0.6 um or less.

2. The bonded wafer according to claim 1, wherein the bonding material is of a thermosetting type and has a thermal softening point lower than a thermosetting temperature.

3. The bonded wafer according to claim 1 or 2, wherein the bonding material comprises one or more of epoxy resin, benzocyclobutene (BCB), SOG (spin-on-glass), PI (polyimide), and fluororesin.

4. The bonded wafer according to any one of claims 1 to 3, wherein the bonding material is in a softened state.

5. A method for producing a bonded wafer comprising:
(1) a step of producing an epitaxial wafer having a heterojunction structure by laminating a material with a different thermal expansion coefficient on a growth substrate by epitaxial growth,
(2) a step of preparing a support substrate, and
(3) a step of bonding an epitaxial growth layer of the epitaxial wafer and the support substrate via a bonding material,
wherein the bonding material has an average thickness of 0.01 µm or more and 0.6 um or less.

6. The method for producing a bonded wafer according to claim 5, wherein the bonding material is of a thermosetting type and has a thermal softening point lower than a thermosetting temperature.

7. The method for producing a bonded wafer according to claim 5 or 6, wherein the bonding material comprises one or more of epoxy resin, benzocyclobutene (BCB), SOG (spin-on-glass), PI (Polyimide), and fluororesin.

8. A method for producing a bonded wafer comprising:
(1) a step of producing an epitaxial wafer having a heterojunction structure by laminating a material with a different thermal expansion coefficient on a growth substrate by epitaxial growth,
(2) a step of preparing a support substrate, and
(3) a step of bonding an epitaxial growth layer of the epitaxial wafer and the support substrate via a bonding material,
wherein a thermosetting material is applied and cured on the epitaxial growth layer, and the support substrate is further bonded thereon via the bonding material having an average thickness of 0.01 um or more and 0.6 um or less.
